# EUROPEAN PATENT APPLICATION

(11) **EP 4 676 177 A1**
(43) Date of publication of application: **07.01.2026**
(21) Application number: 24824937.7
(22) Date of filing: 15.03.2024
(51) Int. Cl.: H05K 9/00

(54) **ELECTRONIC DEVICE**

(30) Priority: 21.06.2023 CN 202310745704
(71) Applicant: Honor Device Co., Ltd., Shenzhen, Guangdong 518040 (CN)
(72) Inventor: YAN, Bin, Shenzhen, Guangdong 518040 (CN); ZHOU, Guotong, Shenzhen, Guangdong 518040 (CN); LIU, Xiulan, Shenzhen, Guangdong 518040 (CN)
(74) Representative: MERH-IP Matias Erny Reichl Hoffmann Patentanwälte PartG mbB
(86) International application number: PCT/CN2024/081846
(87) International publication number: WO 2024/260035

(57) **Abstract**

This application relates to the field of terminal technologies, and discloses an electronic device. The electronic device includes a circuit board, an electromagnetic shielding assembly, and a functional device. The circuit board has a first board surface, and the first board surface includes a wiring region. The electromagnetic shielding assembly is superposed on a side of the circuit board that has the first board surface, and the electromagnetic shielding assembly includes a conductive fabric. The conductive fabric is in insulated connection to the wiring region. An orthographic projection region of the conductive fabric in a projection plane is a first projection region, and the projection plane is perpendicular to a direction in which the electromagnetic shielding assembly is superposed on the circuit board. The functional device is arranged on a side of the electromagnetic shielding assembly that faces away from the circuit board, and an orthographic projection region of the functional device in the projection plane is a second projection region. The first projection region does not coincide with the second projection region. In the electronic device according to this application, the conductive fabric and the functional device are staggered in the projection plane, so that a thickness space is effectively saved, and an overall thickness is reduced.

## Description

This application claims priority to Chinese Patent Application No. 202310745704.0, entitled "ELECTRONIC DEVICE" filed with the China National Intellectual Property Administration on June 21, 2023, which is incorporated herein by reference in its entirety.

### TECHNICAL FIELD

This application relates to the field of terminal technologies, and in particular, to an electronic device.

### BACKGROUND

To meet user experience, an electronic device gradually develops toward lightening and thinning and miniaturization, and an overall thickness of the electronic device gradually decreases. However, in the existing electronic device, components are usually stacked in a thickness direction of the electronic device, and the components occupy a large thickness space. This is not beneficial to a lightening and thinning design of the electronic device.

For example, to reduce a thickness of a foldable phone in a folded state, the thickness of the foldable phone in an unfolded state needs to be smaller than that of a conventional electronic device such as a bar phone and a Slate, and an inner space of the foldable phone is also smaller.

A back adhesive, a circuit board, an electromagnetic shielding assembly, and a functional device that are stacked in a thickness direction of the foldable phone are arranged in the foldable phone. The back adhesive is configured to fix the circuit board to a display screen. The circuit board can be electrically connected to another component (for example, a display module) to transmit a signal, thereby implementing various functions (for example, a screen display function) of the foldable phone. The electromagnetic shielding assembly can prevent another electronic component from interfering with normal operation of the circuit board. The functional device is configured to implement various functions, such as protecting a battery or dissipating heat from the battery. However, in this layout scheme, a large overall thickness is occupied, which cannot meet a thinning requirement.

### SUMMARY

To solve the foregoing problem that an electronic device has a large thickness and cannot meet a thinning requirement, this application provides an electronic device with a compact structure.

According to a first aspect, this application provides an electronic device. The electronic device includes a circuit board, an electromagnetic shielding assembly, and a functional device. The circuit board has a first board surface, and the first board surface includes a wiring region. The electromagnetic shielding assembly is superposed on a side of the circuit board that has the first board surface, and the electromagnetic shielding assembly includes a conductive fabric. The conductive fabric is in insulated connection to the wiring region. An orthographic projection region of the conductive fabric in a projection plane is a first projection region, and the projection plane is perpendicular to a direction in which the electromagnetic shielding assembly is superposed on the circuit board. The functional device is arranged on a side of the electromagnetic shielding assembly that faces away from the circuit board, and an orthographic projection region of the functional device in the projection plane is a second projection region. The first projection region does not coincide with the second projection region.

It can be understood that the electronic device may include, but is not limited to, an electronic device with a circuit board, such as a mobile phone (for example, a foldable phone or a bar phone), a tablet computer, a notebook computer, an ultra-mobile personal computer (ultra-mobile personal computer, UMPC), a handheld computer, a touch TV, a walkie-talkie, a netbook, a personal digital assistant (personal digital assistant, PDA), a wearable device, a virtual reality device, an intelligent vehicle, an intelligent robot, and an industrial device.

According to the implementation of this application, the first projection region does not coincide with the second projection region. That is, the conductive fabric and the functional device are staggered in the projection plane. In the projection plane, the conductive fabric is located in a region outside the functional device. This reduces a distance between the conductive fabric and the electromagnetic shielding assembly in the direction in which the electromagnetic shielding assembly is superposed on the circuit board, thereby reducing an overall thickness of the electronic device.

In the electronic device, the conductive fabric and the functional device are staggered in the projection plane, so that more thickness space is saved, a design requirement for lightening and thinning is met, and the application range is wide.

In a possible implementation of the first aspect, the first projection region is arranged around the second projection region. This further improves an electromagnetic shielding effect of the conductive fabric while meeting the thinning requirement for the electronic device, thereby meeting an electromagnetic shielding requirement for the electronic device in various application scenarios.

In a possible implementation of the first aspect, the first projection region is in a C shape or a shape of a square.

Based on this, the conductive fabric can better cover the wiring region of the circuit board while meeting requirements for thinning and space saving, thereby further improving the electromagnetic shielding effect and effectively avoiding the problems of signal distortion, and the like caused by electromagnetic interference during signal transmission.

In a possible implementation of the first aspect, the electromagnetic shielding assembly further includes a first protection layer, and the first protection layer is arranged on a surface of the conductive fabric that faces the circuit board. This causes the conductive fabric to be in insulated connection to the wiring region of the circuit board. In addition, the first protection layer can also implement protection against water and dust, and the like.

In a possible implementation of the first aspect, the electromagnetic shielding assembly further includes a second protection layer, and the second protection layer is arranged on a surface of the conductive fabric that faces away from the circuit board. This can implement insulation, protection against water and dust, and the like.

In a possible implementation of the first aspect, an orthographic projection region of the first protection layer in the projection plane is a third projection region, and an orthographic projection region of the second protection layer in the projection plane is a fourth projection region; and
the third projection region does not coincide with the second projection region, and a ratio of an area of the fourth projection region to a sum of an area of the first projection region and an area of the second projection region is 0.8 to 1.5,
   or
the fourth projection region does not coincide with the second projection region, and a ratio of an area of the third projection region to the sum of the area of the first projection region and the area of the second projection region is 0.8 to 1.5.

According to the implementation of this application, the third projection region does not coincide with the second projection region. That is, the first protection layer and the functional device are staggered in the projection plane, thereby further reducing the thickness of the electronic device.

The ratio of the area of the fourth projection region to the sum of the area of the first projection region and the area of the second projection region may be 0.8 to 1.5, for example, 0.8, 0.9, 1, or 1.1.

Based on this, the second protection layer can cover the circuit board and the conductive fabric in a large area. Therefore, the second protection layer can effectively prevent a liquid (for example, water) from damaging the circuit board and the conductive fabric while implementing insulation, thereby further improving operation reliability of the circuit board and the conductive fabric.

Alternatively, the fourth projection region does not coincide with the second projection region. That is, in the projection plane, the second protection layer is distributed in a region outside the functional device, thereby further reducing the thickness of the electronic device.

The ratio of the area of the third projection region to the sum of the area of the first projection region and the area of the second projection region may be 0.8 to 1.5, for example, 0.8, 0.9, 1, or 1.1. The first protection layer can cover the circuit board and the conductive fabric in a large area. The first protection layer can effectively prevent a liquid (for example, water) from damaging the circuit board and the conductive fabric while implementing insulation, thereby further improving operation reliability of the circuit board and the conductive fabric.

In a possible implementation of the first aspect, the electronic device further includes a first cover plate, where the circuit board is secured to the first cover plate by a back adhesive, an orthographic projection region of the back adhesive in the projection plane is a fifth projection region, and the fifth projection region does not coincide with the second projection region.

According to the implementation of this application, the fifth projection region does not coincide with the second projection region. That is, in the projection plane, the back adhesive is distributed in a region outside the functional device, thereby further reducing the overall thickness of the electronic device.

In a possible implementation of the first aspect, the electronic device further includes a battery, where the battery is arranged on the side of the electromagnetic shielding assembly that faces away from the circuit board, and the functional device is at least partially located between the battery and the electromagnetic shielding assembly.

In a possible implementation of the first aspect, the back adhesive includes a first portion, the first portion is located between the first cover plate and the battery, an orthographic projection of the first portion on the projection plane is a first projection subregion, and the first projection subregion is located outside the first projection region.

According to the implementation of this application, the first projection subregion is located outside the first projection region. That is, the first portion of the back adhesive and the conductive fabric are staggered in the projection plane, thereby effectively preventing the back adhesive and the conductive fabric from occupying an excessive thickness space, and further reducing the overall thickness of the electronic device.

In a possible implementation of the first aspect, the circuit board is a flexible printed circuit.

In a possible implementation of the first aspect, the first cover plate is a display module, and the circuit board is electrically connected to the display module.

In a possible implementation of the first aspect, the functional device is mylar or a graphite sheet.

### BRIEF DESCRIPTION OF DRAWINGS

FIG. 1A is a first perspective view of a foldable phone in a flattened state according to an embodiment of this application;
FIG. 1B is a second perspective view of a foldable phone in a flattened state according to an embodiment of this application;
FIG. 1C is a perspective view of a foldable phone in a folded state according to an embodiment of this application;
FIG. 2 is an exploded view of a first phone body of a foldable phone according to an embodiment of this application;
FIG. 3A is a schematic diagram of a structure of a circuit board in a first phone body of a foldable phone according to an embodiment of this application;
FIG. 3B is a schematic diagram of a structure of an electromagnetic shielding assembly in a first phone body of a foldable phone according to an embodiment of this application;
FIG. 4A is a sectional view of a first phone body taken along line A-A of FIG. 3B in some technical solutions;
FIG. 4B is a partial enlarged view of a first phone body at a conductive fabric in some technical solutions;
FIG. 5A is an exploded view of a first phone body according to an embodiment of this application, where no middle frame is shown;
FIG. 5B is a sectional view of a first phone body taken along line B-B of FIG. 5A according to an embodiment of this application, where no middle frame is shown;
FIG. 5C is a partial enlarged view of a first phone body at a conductive fabric according to an embodiment of this application;
FIG. 6 shows an example shape of a first projection region according to some other embodiments of this application;
FIG. 7 is a schematic diagram of a structure of a first protection layer in a foldable phone according to an embodiment of this application;
FIG. 8 is a schematic diagram of a structure of a second protection layer in a foldable phone according to an embodiment of this application;
FIG. 9 shows an example structure of a first protection layer and a second protection layer in a foldable phone according to some other embodiments of this application;
FIG. 10 is a schematic diagram of an orthographic projection region of a back adhesive in a foldable phone in a projection plane according to an embodiment of this application;
FIG. 11A is a schematic diagram of a structure of a first phone body at a stacking region in some technical solutions;
FIG. 11B is a schematic diagram of a structure of a first phone body of a foldable phone at a stacking region according to an embodiment of this application;
FIG. 12 shows an example arrangement manner of a first projection subregion according to an embodiment of this application;
FIG. 13A is a perspective view of a bar phone according to some embodiments of this application; and
FIG. 13B is a sectional view of a bar phone taken along line C-C of FIG. 13A according to some embodiments of this application.

Description of reference signs: 1 - Foldable phone; 10 - First phone body; 100 - First housing; 110 - First cover plate; 120 - Second cover plate; 200 - Circuit board; 210 - First board surface; 220 - Second board surface; 230 - Electronic component; 300 - Electromagnetic shielding assembly; 310 - Conductive fabric; 320 - First protection layer; 330 - Second protection layer; 400 - Functional device; 410 - First portion of the functional device; 420 - Second portion of the functional device; 430 - Third portion of the functional device; 500 - Battery; 600 - Middle frame; 700 - Back adhesive; 710 - First portion of the back adhesive; 720 - Second portion of the back adhesive; 10a - First phone body; 300a - Electromagnetic shielding assembly; 310a - Conductive fabric; 320a - First protection layer; 330a - Second protection layer; 700a - Back adhesive; 20 - Second phone body; 30 - Rotating shaft mechanism; 40 - Flexible screen assembly; 2 - Bar phone; 21 - Display screen module; 22 - Housing; 23 - Accommodating cavity; G1 - Safety gap; S1 - First projection region; S2 - Second projection region; S3 - Third projection region; S4 - Fourth projection region; S5 - Fifth projection region; S5a - First projection subregion; S5b - Second projection subregion; Sa - Wiring region; Sb - Stacking region; Sc - Spacing region; D0 - Thickness of the electromagnetic shielding assembly; D1- Thickness of the conductive fabric; D2 - Thickness of the first protection layer; D3 - Thickness of the second protection layer; D4 - Thickness of the back adhesive.

### DESCRIPTION OF EMBODIMENTS

To make the objectives, technical solutions, and advantages of this application clearer, implementations of this application are further described in detail below with reference to the accompanying drawings.

This application provides an electronic device. The electronic device according to this application has a compact structure, can effectively reduce an overall thickness, and meets a design requirement for lightening and thinning.

It can be understood that the electronic device according to this application may include, but is not limited to, an electronic device with a circuit board, such as a mobile phone (for example, a foldable phone or a bar phone), a tablet computer, a notebook computer, an ultra-mobile personal computer (ultra-mobile personal computer, UMPC), a handheld computer, a touch TV, a walkie-talkie, a netbook, a personal digital assistant (personal digital assistant, PDA), a wearable device, a virtual reality device, an intelligent vehicle, an intelligent robot, and an industrial device. For ease of description, an example in which an electronic device is a foldable phone is used for description below. In addition, for ease of description, a state of the foldable phone after the foldable phone is folded is defined as a folded state, a state of the foldable phone after the foldable phone is flattened is defined as a flattened state, and a state of the foldable phone between the folded state and the flattened state is defined as an intermediate state.

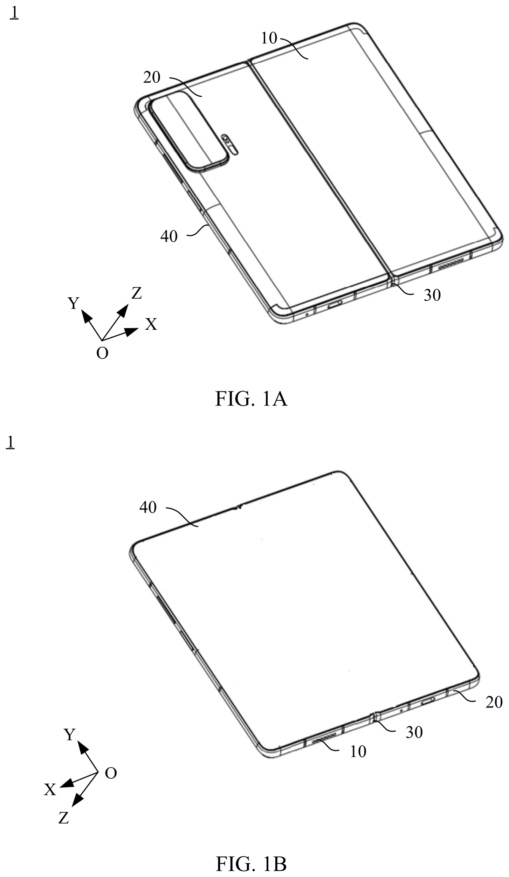

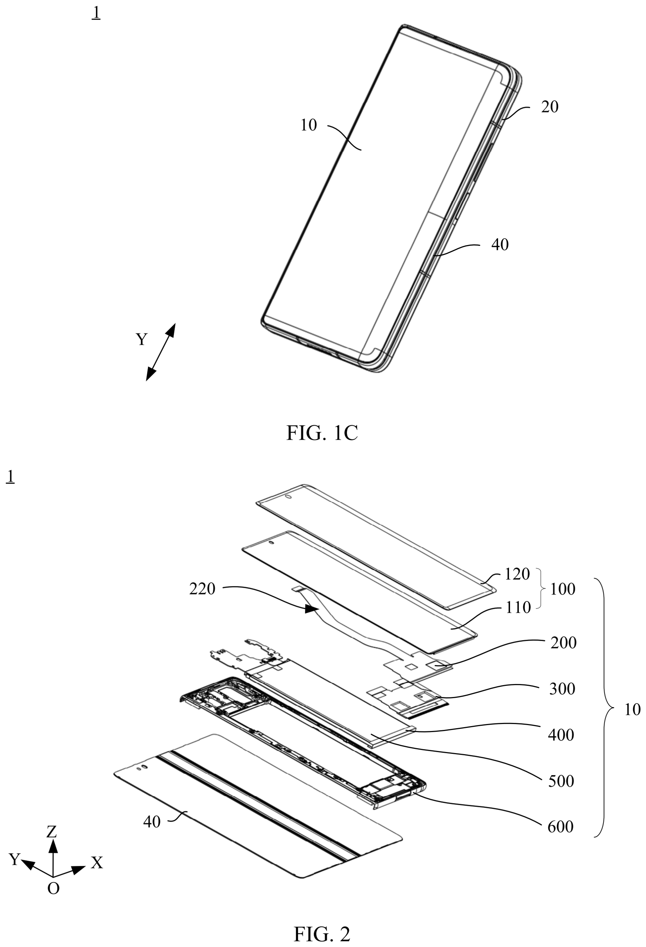

FIG. 1A is a first perspective view of a foldable phone 1 in a flattened state according to an embodiment of this application. FIG. 1B is a second perspective view of a foldable phone 1 in a flattened state according to an embodiment of this application. FIG. 1C is a perspective view of a foldable phone 1 in a folded state according to an embodiment of this application.

Referring to FIG. 1A to FIG. 1C, the foldable phone 1 includes a first phone body 10, a second phone body 20, a rotating shaft mechanism 30, and a flexible screen assembly 40. The first phone body 10 and the second phone body 20 are arranged on two opposite sides of the rotating shaft mechanism 30 respectively. The first phone body 10 and the second phone body 20 each are connected to the rotating shaft mechanism 30, and can rotate relatively. The flexible screen assembly 40 is secured to the first phone body 10, the second phone body 20, and the rotating shaft mechanism 30. For example, the first phone body 10, the second phone body 20, and the rotating shaft mechanism 30 are covered by the flexible screen assembly 40. The first phone body 10 and the second phone body 20 rotate relatively through the rotating shaft mechanism 30, and can drive the flexible screen assembly 40 to bend or flatten, so that the foldable phone 1 can be switched between the flattened state shown in FIG. 1A and FIG. 1B and the folded state shown in FIG. 1C.

In some embodiments of this application, various electronic components may be arranged inside the first phone body 10 and the second phone body 20 to implement various functions of the foldable phone 1. For ease of description, the first phone body 10 is used as an example below to describe internal electronic components and related functions of the first phone body.

To facilitate subsequent description, before an internal specific structure of the foldable phone 1 is described, in this application, an X-axis direction, a Y-axis direction, and a Z-axis direction corresponding to the foldable phone 1 are first defined with reference to FIG. 1A and FIG. 1B. Referring to FIG. 1A and FIG. 1B, the X-axis direction and the Y-axis direction are parallel to a plane in which the flexible screen assembly 40 is located. That is, an XOY plane is parallel to the plane in which the flexible screen assembly 40 is located. The X-axis direction is a direction from the first phone body 10 to the second phone body 20 when the foldable mobile phone 1 is in a flattened state. The Y-axis direction is perpendicular to the X-axis direction. The Z-axis direction is a thickness direction when the foldable phone 1 is in the flattened state. It should be noted that, a thickness of each component refers to a dimension of the component in the Z-axis direction. Details are not described below.

In some implementation of this application, the X-axis direction, the Y-axis direction, and the Z-axis direction are mutually perpendicular. It can be understood that the mutual perpendicularity in this application is not absolute perpendicularity, and approximate perpendicularity (for example, an included angle between two structural features is 89.9°) caused by a machining error and an assembly error is also within the scope of mutual perpendicularity in this application. This is not specifically limited in this application, and the definition on the mutual perpendicularity is not described repeatedly below.

FIG. 2 is an exploded view of a first phone body 10 of a foldable phone 1 according to an embodiment of this application. For example, as shown in FIG. 2, the first phone body 10 includes a first housing 100, a circuit board 200, an electromagnetic shielding assembly (or referred to as a conductive fabric assembly (covertape)) 300, a functional device 400, a battery 500, and a middle frame 600. The first housing 100 and the middle frame 600 are oppositely arranged in the Z-axis direction, and the circuit board 200, the electromagnetic shielding assembly 300, and the battery 500 are located between the first housing 100 and the middle frame 600.

Specifically, the first housing 100 includes a first cover plate 110 and a second cover plate 120. The first cover plate 110 is located between the second cover plate 120 and the middle frame 600. For example, the first housing 100 may be an outer screen with a display function. The first cover plate 110 may be a display module with a display function. The second cover plate 120 may be a cover glass (CG) to protect the first cover plate 110.

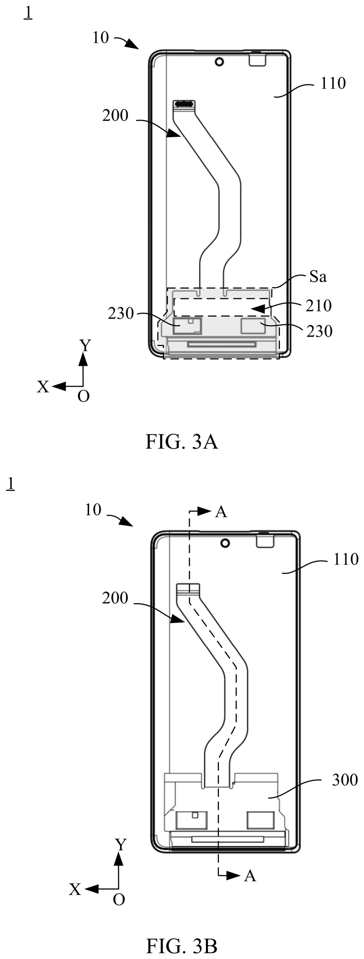

FIG. 3A is a schematic diagram of a structure of a circuit board 200 in a first phone body 10 of a foldable phone 1 according to an embodiment of this application. With reference to FIG. 2 and FIG. 3A, in some embodiments of this application, the circuit board 200 may be a flexible printed circuit (flexible printed circuit, FPC). For example, the circuit board 200 may be configured to connect a mainboard (not shown) to the first cover plate 110, so that the mainboard can transmit various data signals to the first cover plate 110, and the first cover plate 110 can display different information such as images and videos based on different data signals.

The circuit board 200 has a first board surface 210 and a second board surface 220. The first board surface 210 and the second board surface 220 face away from each other in the Z-axis direction. The first board surface 210 faces away from the first cover plate 110. The second board surface 220 faces the first cover plate 110.

The first board surface 210 includes a wiring region Sa. For example, the wiring region Sa may be a dark irregular region defined by dashed lines in FIG. 3A. For example, there may be an exposed signal transmission line in the wiring region Sa, to lead a signal out of the circuit board 200 to another circuit board or assembly. Alternatively, the wiring region Sa may be used as a welding region to facilitate connection of another electronic element to the circuit board 200. Alternatively, the wiring region Sa may be used as a ground point for the circuit board 200 to ensure that the circuit board 200 can operate normally.

In some embodiments of this application, a plurality of electronic components 230 may be further mounted on the first board surface 210. The plurality of electronic components 230 can form different circuits to implement various functions. For example, the circuit board 200 can transmit a data signal of the mainboard to the first cover plate 110 through the circuits.

FIG. 3B is a schematic diagram of a structure of an electromagnetic shielding assembly 300 in a first phone body 10 of a foldable phone 1 according to an embodiment of this application. With reference to FIG. 2, FIG. 3A, and FIG. 3B, the electromagnetic shielding assembly 300 is superposed on a side of the circuit board 200 that has the first board surface 210. It can be understood that a direction in which the electromagnetic shielding assembly 300 is superposed on the circuit board 200 is a Z-axis direction. The electromagnetic shielding assembly 300 covers the wiring region Sa of the circuit board 200. In addition, the electromagnetic shielding assembly 300 is in insulated connection to the wiring region Sa to prevent the electromagnetic shielding assembly 300 from being connected to the wiring region Sa.

The electromagnetic shielding assembly 300 can implement grounding and electromagnetic shielding for the circuit board 200, thereby avoiding interference between the circuit board 200 and another component (for example, the battery 500), and further ensuring the normal operation of the foldable phone 1.

It can be understood that the functional device 400 is located on a side of the electromagnetic shielding assembly 300 that faces away from the circuit board 200. That is, an orthographic projection region of the functional device 400 in a projection plane at least partially overlaps an orthographic projection region of the electromagnetic shielding assembly 300 in the projection plane. The projection plane may be a plane perpendicular to the direction in which the electromagnetic shielding assembly 300 is superposed on the circuit board 200 (that is, the Z-axis direction). For example, the projection plane may be an XOY plane.

In some embodiments of this application, the functional device 400 may be arranged on the battery 500. For example, the battery 500 is located on a side of the electromagnetic shielding assembly 300 that faces away from the circuit board 200. The functional device 400 may be wrapped at an end portion of the battery 500. Moreover, at least a portion of the functional device 400 is located between the electromagnetic shielding assembly 300 and the battery 500 in the Z-axis direction. The portion of the functional device 400 that is located between the electromagnetic shielding assembly 300 and the battery 500 has a thickness of about 0.05 mm.

The functional device 400 can protect the battery 500. For example, the functional device 400 may be mylar (mylar), and the mylar can be waterproof and bump-proof. Alternatively, in another alternative implementation, the functional device 400 may be a heat dissipation component. For example, the functional device 400 may alternatively be a graphite sheet, and the graphite sheet can conduct heat, thereby dissipating heat generated by the battery 500.

It can be understood that the above embodiment is described only with an example in which the functional device 400 is arranged on the battery 500. In some other embodiments, the functional device 400 may alternatively be arranged on another device (for example, a circuit board module). This is not limited by this application.

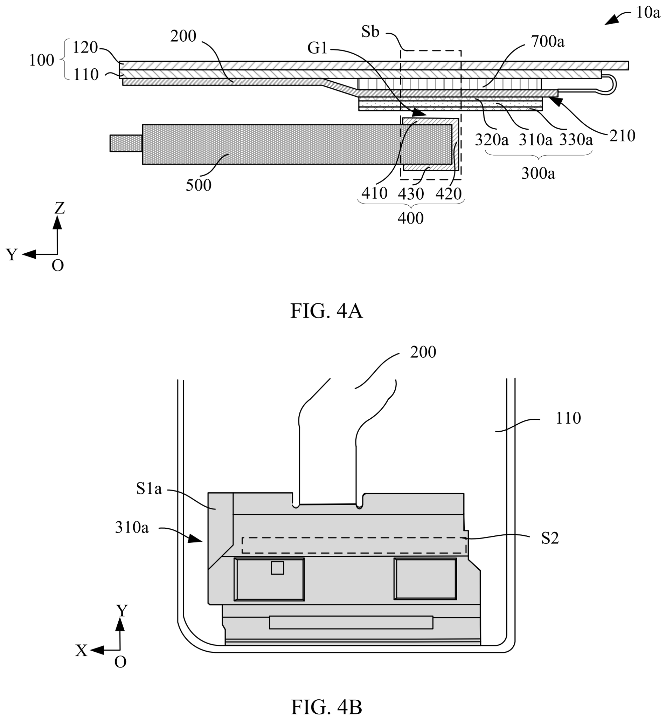

FIG. 4A is a sectional view of a first phone body 10a taken along line A-A of FIG. 3B in some technical solutions. FIG. 4B is a partial enlarged view of a first phone body 10a at a conductive fabric 310a in some technical solutions. It should be noted that, to facilitate description of an internal specific layout of the first phone body 10a, a battery 500 is further shown in FIG. 4A.

With reference to FIG. 4A and FIG. 4B, the circuit board 200 is secured to a first cover plate 110 by a back adhesive 700a. The electromagnetic shielding assembly 300a includes a conductive fabric 310a, a first protection layer 320a, and a second protection layer 330a. In a Z-axis direction, the first protection layer 320a is arranged on a surface of the conductive fabric 310a that faces the circuit board 200, and the second protection layer 330 is arranged on a surface of the conductive fabric 310a that faces away from the circuit board 200. An orthographic projection region of the conductive fabric 310a in the projection plane is a first projection region S1a. For example, the first projection region S1a may be a dark irregular region in FIG. 4B.

The battery 500 is located on a side of the electromagnetic shielding assembly 300a that faces away from the circuit board 200. The functional device 400 is arranged at an end portion of the battery 500 in a Y-axis direction. The functional device 400 includes a first portion 410, a second portion 420, and a third portion 430 that are sequentially connected. The first portion 410 is located between the electromagnetic shielding assembly 300a and the battery 500. The second portion 420 is located at the end portion of the battery 500 and is connected to the first portion 410 and the third portion 430. The third portion 430 is located on a side of the battery 500 that faces away from the electromagnetic shielding assembly 300a.

An orthographic projection region of the functional device 400 in the projection plane is a second projection region S2. For example, the second projection region S2 may be a rectangular region defined by dashed lines in FIG. 4B. The second projection region S2 is located in the first projection region S1a.

A safety gap G1 is reserved between the first portion 410 of the functional device 400 and the electromagnetic shielding assembly 300a in the Z-axis direction to avoid interference between the functional device 400 and the electromagnetic shielding assembly 300a caused by the battery 500 being heated and expanding.

The first phone body 10a includes the second cover plate 120, the first cover plate 110, the back adhesive 700a, the circuit board 200, the first protection layer 320a, the conductive fabric 310a, the second protection layer 330a, the safety gap G1, the first portion 410 of the functional device 400, the battery 500, and the third portion 430 of the functional device 400, a total of eleven layers, which are sequentially stacked in a negative direction of the Z-axis at a stacking region Sb. The stacking is too dense, resulting in a large overall thickness of the first phone body 10a, so that it is difficult to meet a thinning requirement.

To solve the above problems, in the embodiment of this application, the conductive fabric and the functional device are staggered in the projection plane, to effectively compress a distribution space of the conductive fabric and the functional device in the Z-axis direction, thereby further improving compactness of the structure, effectively reducing the overall thickness of the foldable phone, and meeting the thinning requirement for the foldable phone. The following describes the technical solutions of this application with reference to the accompanying drawings.

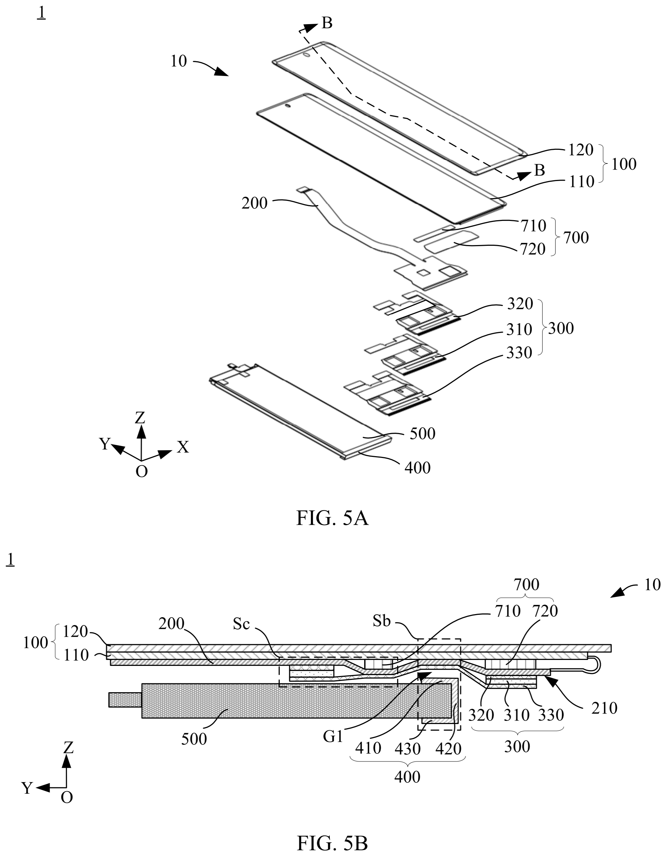

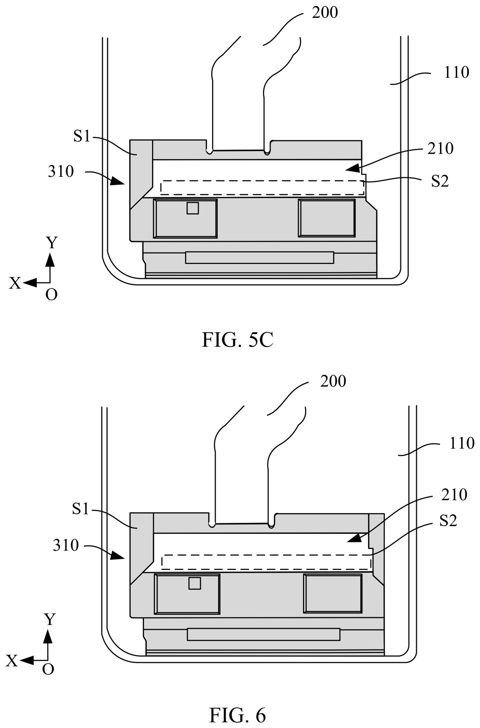

FIG. 5A is an exploded view of a first phone body 10 according to an embodiment of this application, where no middle frame 600 is shown. FIG. 5B is a sectional view of a first phone body 10 taken along line B-B of FIG. 5A according to an embodiment of this application, where no middle frame 600 is shown. FIG. 5C is a partial enlarged view of a first phone body 10 at a conductive fabric 310 according to an embodiment of this application.

Referring to FIG. 5A to FIG. 5C, the first phone body 10 includes a first housing 100, a circuit board 200, an electromagnetic shielding assembly 300, a functional device 400, and a battery 500 that are sequentially arranged in a negative direction of a Z-axis.

The circuit board 200 has a first board surface 210. The first board surface 210 includes a wiring region (for example, the wiring region Sa shown in FIG. 3A).

The electromagnetic shielding assembly 300 is arranged on a side of the circuit board 200 that has the first board surface 210. The electromagnetic shielding assembly 300 includes a conductive fabric 310. The conductive fabric 310 is in insulated connection to the wiring region of the circuit board 200, to implement grounding and electromagnetic shielding. An orthographic projection region of the conductive fabric 310 in the projection plane is a first projection region S1. For example, the first projection region S1 may be a dark irregular region shown in FIG. 5C. Correspondingly, the wiring region of the circuit board 200 may be a region occupied by the dark irregular region in FIG. 5C.

The functional device 400 is located on a side of the electromagnetic shielding assembly 300 that faces away from the circuit board 200. An orthographic projection region of the functional device 400 in the projection plane is a second projection region S2. The second projection region S2 may be a rectangular region defined by dashed lines shown in FIG. 5C.

For example, the functional device 400 may be wrapped at an end portion of the battery 500. The functional device 400 includes a first portion 410, a second portion 420, and a third portion 430 that are sequentially connected. The first portion 410 is located between the electromagnetic shielding assembly 300 and the battery 500. The second portion 420 is located at the end portion of the battery 500 and is connected to the first portion 410 and the third portion 430. The third portion 430 is located on a side of the battery 500 that faces away from the electromagnetic shielding assembly 300. That is, the second projection region S2 at least partially overlaps an orthographic projection of the electromagnetic shielding assembly 300 on the projection plane. For example, as shown in FIG. 5A to FIG. 5C, the second projection region S2 is located in an orthographic projection region (not shown) of the electromagnetic shielding assembly 300 in the projection plane.

The first projection region S1 does not coincide with the second projection region S2. That is, the conductive fabric 310 and the functional device 400 are staggered in the projection plane. In an XOY plane, the conductive fabric 310 is located in a region outside the functional device 400, and a distance between the functional device 400 and the circuit board 200 may be smaller, to reduce the overall thickness of the foldable phone 1.

In the foldable phone 1, by an appropriate design of the layout between the conductive fabric 310 and the functional device 400, concentration of component stacking at the stacking region Sb is effectively reduced, thereby saving more thickness space, and meeting the design requirement of lightening and thinning.

For example, in comparison between FIG. 4A and FIG. 4B, and FIG. 5B and FIG. 5C, similarly, the conductive fabric and the functional device are stacked in the first phone body, but when the conductive fabric 310a and the functional device 400 in the first phone body 10a are both stacked at the stacking region Sb, the conductive fabric 310a and the functional device 400 occupy more thickness space, which cannot meet the requirement of thinning. In this application, the conductive fabric 310 and the functional device 400 are staggered in the projection plane, so that the thickness is reduced by the thickness of the conductive fabric 310 (for example, 0.03 mm), thereby making the overall structure of the foldable phone 1 more compact, effectively meeting the thinning requirement for the foldable phone 1, and having a wide application range.

In addition, in the layout scheme of the conductive fabric 310, more space may alternatively be reserved for other components, to make full use of the internal space of the foldable phone 1 and improve operating performance of the foldable phone 1. For example, the conductive fabric 310 and the functional device 400 are staggered in the XOY plane, so that the volume of the battery 500 can be designed to be larger, and correspondingly, the capacity of the battery 500 is also larger, thereby enabling a battery life of the foldable phone 1 to be better.

Still referring to FIG. 5B, in some embodiments of this application, the circuit board 200 is arched in a positive direction of the Z-axis. The circuit board 200 is similarly in an inverted U shape as a whole. However, this is only a schematic illustration and does not constitute a specific limitation on the implementation of this application. In some other embodiments of this application, the circuit board 200 may alternatively be in another form. For example, the circuit board 200 may alternatively similarly be in a shape of a straight line. This is not limited in this application.

In some embodiments of this application, the first projection region S1 may be arranged around the second projection region S2, to further improve an electromagnetic shielding effect of the conductive fabric 310 while meeting the thinning requirement for the foldable mobile phone 1, thereby meeting an electromagnetic shielding requirement for the foldable phone 1 in various application scenarios.

For example, with reference to FIG. 3A and FIG. 5C, the first projection region S1 may be arranged around the second projection region S2 similarly in a C shape. Based on this, the conductive fabric 310 can further better cover the wiring region Sa of the circuit board 200 while meeting requirements of thinning and space saving, thereby further improving the electromagnetic shielding effect and effectively avoiding the problems of signal distortion, and the like caused by electromagnetic interference during signal transmission.

It can be understood that FIG. 5C only schematically shows the shape of the first projection region S1. In some other embodiments, the first projection region S1 may alternatively be in another shape. For example, FIG. 6 shows an example shape of a first projection region S1 according to some other embodiments of this application. With reference to FIG. 6, in some other embodiments of this application, the first projection region S1 may alternatively be in a shape of a square. This is not limited in this application. Any shape of the first projection region S1 that can meet the thinning requirement and the electromagnetic shielding requirement is within the protection scope of this application.

Still referring to FIG. 5A and FIG. 5B, in some embodiments of this application, the electromagnetic shielding assembly 300 may further include a first protection layer 320. The first protection layer 320 is arranged on a surface of the conductive fabric 310 that faces the circuit board 200, so that the conductive fabric 310 is in insulated connection to the wiring region (not shown) of the circuit board 200. In addition, the first protection layer 320 can also implement protection against water and dust, and the like. For example, the first protection layer 320 may be mylar.

In some embodiments of this application, the electromagnetic shielding assembly 300 may further include a second protection layer 330. The second protection layer 330 is arranged on a surface of the conductive fabric 310 that faces away from the circuit board 200. This can implement insulation, protection against water and dust, and the like. For example, the second protection layer 330 may also be mylar.

In some embodiments of this application, when the electromagnetic shielding assembly 300 includes the first protection layer 320 and the second protection layer 330, any one of the first protection layer 320 and the second protection layer 330 may be staggered with the functional device 400 in the XOY plane, to further reduce the thickness of the foldable mobile phone 1 while meeting protection requirements such as insulation and protection against dust and water.

It can be understood that, to meet the protection requirements such as insulation and protection against dust and water, when the electromagnetic shielding assembly 300 includes one of the first protection layer 320 and the second protection layer 330, the protection layer cannot be staggered with the functional device 400 in the XOY plane.

Several example layout manners of the first protection layer 320 and the second protection layer 330 are described below with an example in which the electromagnetic shielding assembly 300 includes the first protection layer 320 and the second protection layer 330.

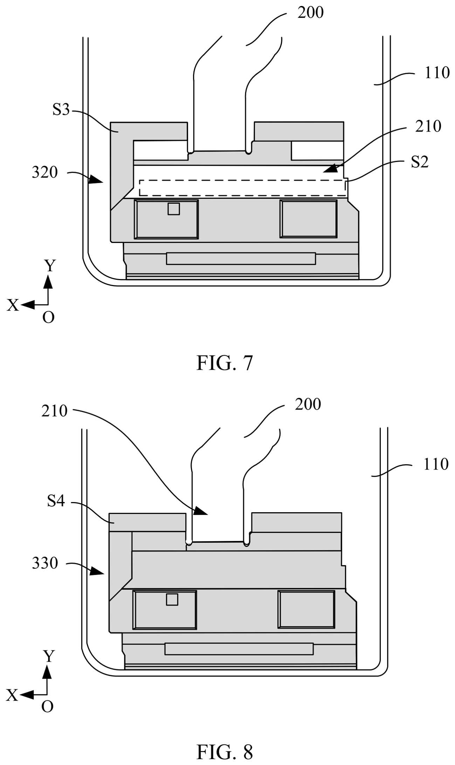

FIG. 7 is a schematic diagram of a structure of a first protection layer 320 in a foldable phone 1 according to an embodiment of this application. FIG. 8 is a schematic diagram of a structure of a second protection layer 330 in a foldable phone 1 according to an embodiment of this application.

To facilitate understanding, before the specific layout manner of the first protection layer 320 and the second protection layer 330 is described, a third projection region S3 and a fourth projection region S4 are first defined with reference to FIG. 7 and FIG. 8.

With reference to FIG. 7 and FIG. 8, an orthographic projection region of the first protection layer 320 in the projection plane is a third projection region S3. For example, the third projection region S3 may be a dark irregular region in FIG. 7. An orthographic projection region of the second protection layer 330 in the projection plane is a fourth projection region S4. For example, the fourth projection region S4 may be a dark irregular region shown in FIG. 8.

With reference to FIG. 5B, FIG. 5C, FIG. 7, and FIG. 8, in some embodiments of this application, the third projection region S3 does not coincide with the second projection region S2. That is, the first protection layer 320 and the functional device 400 are staggered in the XOY plane.

Based on this, the first protection layer 320 occupies no thickness space at the stacking region Sb, thereby further reducing the thickness of the foldable phone 1. For example, the thickness of the first protection layer 320 may be 0.01 mm. Through the above layout scheme that the first protection layer 320 and the functional device 400 are staggered in the XOY plane, the thickness of the foldable phone 1 can be saved by 0.01 mm.

In some implementations, a ratio of an area of the fourth projection region S4 to a sum of an area of the first projection region S1 and an area of the second projection region S2 may be 0.8 to 1.5, for example, 0.8, 0.9, 1, or 1.1.

Based on this, the second protection layer 330 can cover the circuit board 200 and the conductive fabric 310 in a large area. Therefore, the second protection layer 330 can effectively prevent a liquid (for example, water) from damaging the circuit board 200 and the conductive fabric 310 while implementing insulation, thereby further improving operation reliability of the circuit board 200 and the conductive fabric 310.

In some other embodiments of this application, the layout manners of the first protection layer 320 and the second protection layer 330 may be interchanged and combined arbitrarily.

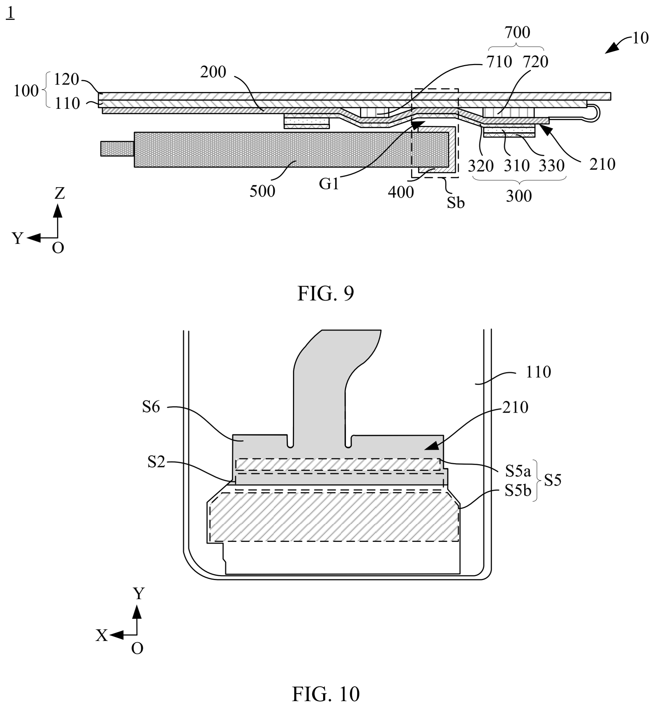

Specifically, FIG. 9 shows an example structure of a first protection layer 320 and a second protection layer 330 in a foldable phone 1 according to some other embodiments of this application. With reference to FIG. 5B, FIG. 5C, and FIG. 7 to FIG. 9, in some other embodiments of this application, the fourth projection region S4 does not coincide with the second projection region S2. That is, the second protection layer 330 and the functional device 400 are staggered in the XOY plane. A ratio of an area of the third projection region S3 to the sum of the area of the first projection region S1 and the area of the second projection region S2 may be 0.8 to 1.5, for example, 0.8, 0.9, 1, or 1.1.

Based on this, the first protection layer 320 can cover the circuit board 200 and the conductive fabric 310 in a large area. The first protection layer 320 can effectively prevent a liquid (for example, water) from damaging the circuit board 200 and the conductive fabric 310 while implementing insulation, thereby further improving operation reliability of the circuit board 200 and the conductive fabric 310. The second protection layer 330 occupies no thickness space at the stacking region Sb, thereby further reducing the thickness of the foldable phone 1.

Still referring to FIG. 5A and FIG. 5B, in some embodiments of this application, the circuit board 200 may be secured to the first cover plate 110 by a back adhesive 700. The back adhesive 700 and the functional device 400 are staggered in the XOY plane, so that the back adhesive 700 occupies no thickness space at the stacking region Sb, thereby further reducing the overall thickness of the foldable phone 1.

FIG. 10 is a schematic diagram of an orthographic projection region of a back adhesive 700 in a foldable phone 1 in a projection plane according to an embodiment of this application. With reference to FIG. 5B, FIG. 9, and FIG. 10, an orthographic projection region of the back adhesive 700 in the projection plane is a fifth projection region S5. For example, the fifth projection region S5 may be two dark regions defined by dashed lines in FIG. 10. The fifth projection region S5 does not coincide with the second projection region S2. That is, the back adhesive 700 and the functional device 400 are staggered in the XOY plane. The back adhesive 700 may occupy no thickness space at the stacking region Sb. For example, the thickness of the back adhesive 700 may be 0.05 mm. The back adhesive 700 and the functional device 400 are staggered in the projection plane, so that the thickness can be reduced by the thickness of one layer of back adhesive 700 (for example, 0.05 mm), which is beneficial to the lightening and thinning design of the foldable phone 1.

In the foldable phone 1, the conductive fabric 310, the first protection layer 320, and the back adhesive 700 are staggered in the XOY plane, so that the thickness space at the stacking region Sb can be greatly saved, and the overall thickness can be reduced.

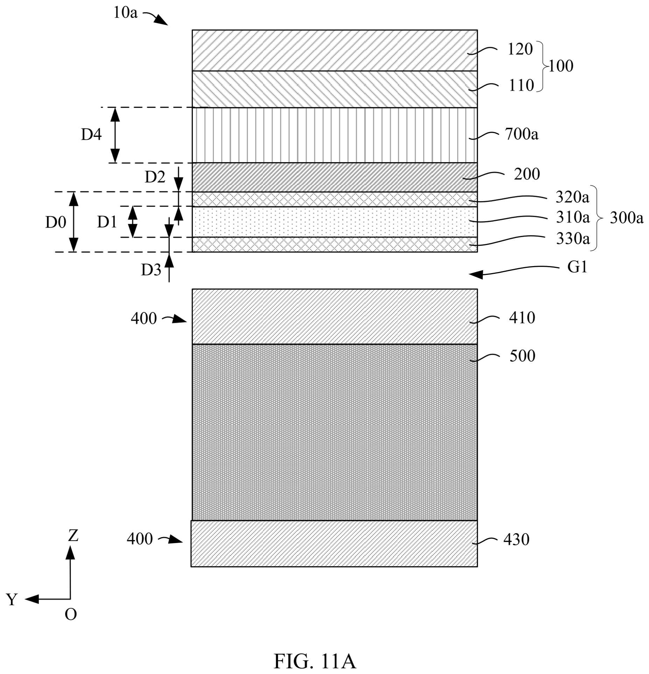

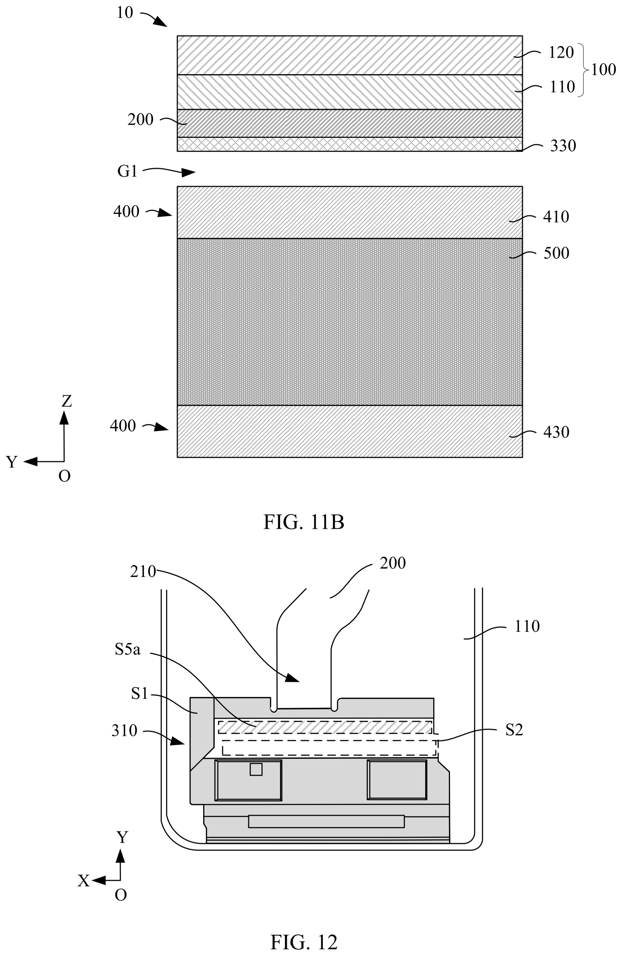

Specifically, FIG. 11A is a schematic diagram of a structure of a first phone body 10a at a stacking region Sb in some technical solutions. FIG. 11B is a schematic diagram of a structure of a first phone body 10 at a stacking region Sb according to an embodiment of this application.

As shown in FIG. 11A, in some technical solutions, the first phone body 10a includes a total of eleven layers of structures, namely a second cover plate 120, a first cover plate 110, a back adhesive 700, a circuit board 200, a first protection layer 320a, a conductive fabric 310a, a second protection layer 330a, a safety gap G1, a first portion 410 of a functional device 400, a battery 500, and a third portion 430 of the functional device 400 that are stacked at the stacking region Sb. For example, a thickness D1 of the conductive fabric 310a is about 0.03 mm. A thickness D2 of the first protection layer 320a is about 0.01 mm. A thickness D3 of the second protection layer 330a is about 0.01 mm. That is, an overall thickness D0 of the electromagnetic shielding assembly 300a in the stacking region Sa is 0.05 m. A thickness D4 of the back adhesive 700a is about 0.05 mm. The first phone body 10a has a large overall thickness, so that it is difficult to meet a thinning requirement.

As shown in FIG. 11B, in this application, at the stacking region Sb, the first phone body 10a includes a second cover plate 120, a first cover plate 110, a circuit board 200, a second protection layer 330, a safety gap G1, a first portion 410 of a functional device 400, a battery 500, and a third portion 430 of the functional device 400, a total of eight layers, which are sequentially arranged in a negative direction of a Z-axis. The first phone body 10 has high compactness of the overall structure, which effectively reduces the overall thickness of the foldable phone 1.

In comparison between FIG. 11A and FIG. 11B, in this application, the conductive fabric 310, the first protection layer 320, the back adhesive 700, and the functional device 400 are staggered, so that the thickness of the first phone body 10 is reduced by a thickness of a three-layer structure (that is, the conductive fabric 310, the first protection layer 320, and the back adhesive 700) compared with the first phone body 10a in an existing technical solution. That is, compared with the prior art, this application can reduce the thickness by 0.09 mm. Therefore, the volume of the battery 500 can be larger, and the capacity of the battery 500 can be increased by about 100 mAh. The first phone body 10 has a more compact structure, occupies a smaller space, and has better working performance.

With reference to FIG. 5A, FIG. 5B, and FIG. 10, in some embodiments of this application, an orthographic projection region of the battery 500 in the projection plane is a sixth projection region S6. For example, the sixth projection region S6 may be a dark irregular region in FIG. 10.

The back adhesive 700 may include a first portion 710 and a second portion 720. The first portion 710 and the second portion 720 are spaced apart in a Y-axis direction. In addition, the first portion 710 is located between the first cover plate 110 and the battery 500. An orthographic projection region of the first portion 710 in the projection plane is a first projection subregion S5a (that is, a rectangular region filled with diagonal lines and defined by dashed lines in FIG. 10). An orthographic projection region of the second portion 720 in the projection plane is a second projection subregion S5b (that is, an irregular region filled with diagonal lines and defined by dashed lines in FIG. 10). In the Y-axis direction, the first projection subregion S5a and the second projection subregion S5b are located on two opposite sides of the second projection region S2, respectively. In addition, the first projection subregion S5a is located in the sixth projection region S6.

FIG. 12 shows an example arrangement manner of a first projection subregion S5a according to an embodiment of this application. With reference to FIG. 5B and FIG. 12, in some embodiments of this application, the first projection subregion S5a does not coincide with the first projection region S1. For example, in the Y-axis direction, the first projection subregion S5a may be located between the first projection region S1 and the second projection region S2. That is, in a spacing region Sc between the first cover plate 110 and the battery 500, the back adhesive 700 and the conductive fabric 310 are staggered in the XOY plane, so that the back adhesive 700 and the conductive fabric 310 can be effectively prevented from occupying an excessive thickness space in the spacing region Sc, and the thickness of the foldable phone 1 can be further reduced.

It can be understood that FIG. 10 and FIG. 12 only schematically show the shape of the fifth projection region S5. In another embodiment, the fifth projection region S5 may alternatively in another shape. For example, the fifth projection region S5 may be similarly in a C shape or a shape of a square. For details, reference may be made to FIG. 5C and FIG. 6 and related descriptions thereof. Details are not described herein. This is not limited in this application. Any shape of the fifth projection region S5 that can secure the circuit board 200 and achieve a thinning effect is within the protection scope of this application.

It should be noted that, this embodiment is an example explanation of the technical solution of this application, and other modifications can be made by a person skilled in the art. For example, in this embodiment, only the circuit board 200, the electromagnetic shielding assembly 300, the functional device 400, the battery 500, and the back adhesive 700 are stacked at the first cover plate 110 in the first phone body 10 as example description. In some other embodiments, the above layout scheme of the electromagnetic shielding assembly 300 and the back adhesive 700 can also be applied to another position of the foldable phone 1 (for example, the flexible screen assembly 40).

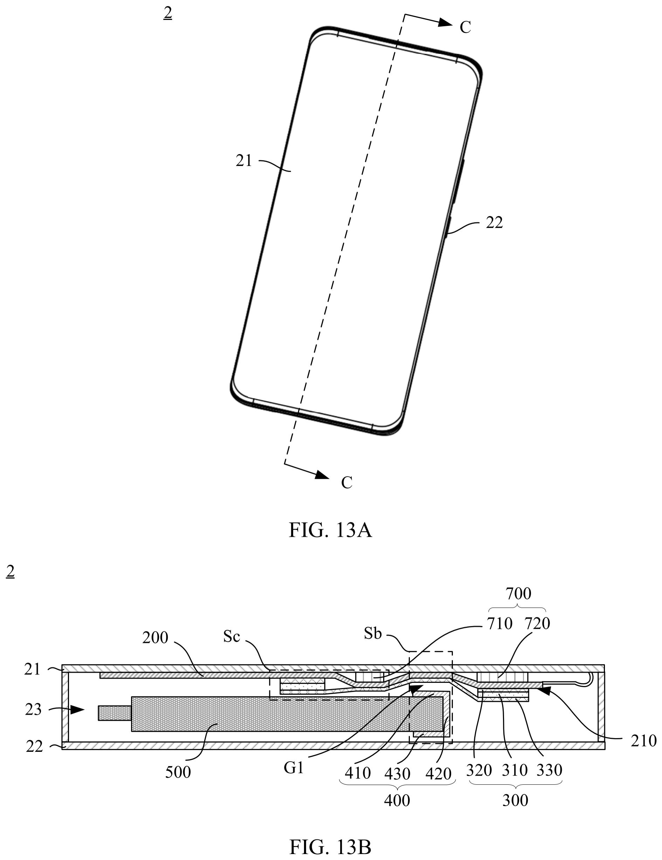

For another example, in this embodiment, an example in which the electronic device is a foldable phone 1, and the first cover plate 110 is an outer screen display module of the foldable phone 1 is used for description. In some other embodiments, the electronic device may alternatively be in another structural form. For example, FIG. 13A is a perspective view of a bar phone 2 according to some embodiments of this application. FIG. 13B is a sectional view of a bar phone 2 taken along line C-C of FIG. 13A according to some embodiments of this application.

With reference to FIG. 13A and FIG. 13B, the electronic device may alternatively be a bar phone 2. The bar phone 2 includes a display screen module 21 (that is, the first cover plate 110 of the above foldable mobile phone 1) and a housing 22. The display screen module 21 is connected to the housing 22, to jointly form an accommodating cavity 23. A circuit board 200, an electromagnetic shielding assembly 300, a functional device 400, a battery 500, and a back adhesive 700 are stacked in the accommodating cavity 23. The circuit board 200 is secured to the display screen module 21 by the back adhesive 700. The electromagnetic shielding assembly 300 is superposed on the circuit board 200. The battery 500 is located on a side of the electromagnetic shielding assembly 300 that faces away from the circuit board 200. The functional device 400 is arranged on the battery 500 and is at least partially located between the electromagnetic shielding assembly 300 and the battery 500.

A specific layout scheme of the electromagnetic shielding assembly 300 and the back adhesive 700 in the bar phone 2 is basically the same as the layout scheme of the electromagnetic shielding assembly 300 and the back adhesive 700 in the foregoing foldable phone 1. Based on this, for the layout scheme of the electromagnetic shielding assembly 300 and the back adhesive 700 in the bar phone 2, reference may be made to FIG. 5A to FIG. 12 and related descriptions thereof. Details are be described herein.

The implementations of this application are described above by specific embodiments, and a person skilled in the art can easily understand other advantages and effects of this application from content disclosed in this specification. Although the descriptions of this application are provided with reference to some embodiments, it does not mean that the features of this application are limited to the implementations. On the contrary, the purpose of describing this application with reference to the implementations is to cover other options or modifications that may be extended based on the claims of this application. This application may be practiced without these details. In addition, to avoid confusing or blurring emphasis of this application, some specific details are omitted in the description. It should be noted that, embodiments of this application and features in the embodiments may be mutually combined in a case that no conflict occurs.

In the descriptions of this application, it should be noted that, an orientation or positional relationship indicated by the term "central", "upper", "lower", "left", "right", "vertical", "horizontal", "outer", "inner", "circumferential", "radial", "axial", or the like is based on the orientation or positional relationship shown in the accompanying drawings, which is only for convenience of describing this application and simplifying the description, rather than indicating or implying that the referred apparatus or element needs to have a particular orientation, be constructed and operated in a particular orientation, and therefore should not be construed as limiting this application.

In the descriptions of this application, it should be noted that, unless otherwise explicitly specified and defined, the terms such as "arranging", "mounting", "connecting", and "fitting" should be understood in a broad sense. For example, they may be a fixed connection, a detachable connection, or an integrated connection; may be a mechanical connection or an electrical connection; and may be a direct connection, an indirect connection by an intermediate medium, or internal communication between two elements. For a person of ordinary skill in the art, the specific meanings of the terms mentioned above in this application can be construed according to specific circumstances.

Obviously, a person skilled in the art can make various modifications and variations to this application without departing from the spirit and scope of this application. In this case, if the modifications and variations made to this application fall within the scope of the claims of this application and equivalent technologies thereof, this application is intended to include these modifications and variations.

## Claims

1. An electronic device, comprising:
a circuit board, wherein the circuit board has a first board surface, and the first board surface comprises a wiring region;
an electromagnetic shielding assembly, wherein the electromagnetic shielding assembly is superposed on a side of the circuit board that has the first board surface, the electromagnetic shielding assembly comprises a conductive fabric, the conductive fabric is in insulated connection to the wiring region, an orthographic projection region of the conductive fabric in a projection plane is a first projection region, and the projection plane is perpendicular to a direction in which the electromagnetic shielding assembly is superposed on the circuit board; and
a functional device, wherein the functional device is arranged on a side of the electromagnetic shielding assembly that faces away from the circuit board, an orthographic projection region of the functional device in the projection plane is a second projection region, and
the first projection region does not coincide with the second projection region.

2. The electronic device according to claim 1, wherein the first projection region is arranged around the second projection region.

3. The electronic device according to claim 2, wherein the first projection region is in a C shape or a shape of a square.

4. The electronic device according to claim 1, wherein the electromagnetic shielding assembly further comprises a first protection layer, and the first protection layer is arranged on a surface of the conductive fabric that faces the circuit board.

5. The electronic device according to claim 4, wherein the electromagnetic shielding assembly further comprises a second protection layer, and the second protection layer is arranged on a surface of the conductive fabric that faces away from the circuit board.

6. The electronic device according to claim 5, wherein an orthographic projection region of the first protection layer in the projection plane is a third projection region, the third projection region does not coincide with the second projection region, and an orthographic projection region of the second protection layer in the projection plane is a fourth projection region; and
a ratio of an area of the fourth projection region to a sum of an area of the first projection region and an area of the second projection region is 0.8 to 1.5, or
the fourth projection region does not coincide with the second projection region, and a ratio of an area of the third projection region to the sum of the area of the first projection region and the area of the second projection region is 0.8 to 1.5.

7. The electronic device according to any one of claims 1 to 6, further comprising a first cover plate, wherein the circuit board is secured to the first cover plate by a back adhesive, an orthographic projection region of the back adhesive in the projection plane is a fifth projection region, and the fifth projection region does not coincide with the second projection region.

8. The electronic device according to claim 7, further comprising a battery, wherein the battery is arranged on the side of the electromagnetic shielding assembly that faces away from the circuit board, and the functional device is at least partially located between the battery and the electromagnetic shielding assembly.

9. The electronic device according to claim 8, wherein the back adhesive comprises a first portion, the first portion is located between the first cover plate and the battery, a projection of the first portion on the projection plane is a first projection subregion, and the first projection subregion does not coincide with the first projection region.

10. The electronic device according to any one of claims 7 to 9, wherein the circuit board is a flexible printed circuit.

11. The electronic device according to any one of claims 7 to 10, wherein the first cover plate is a display module, and the circuit board is electrically connected to the display module.

12. The electronic device according to any one of claims 1 to 11, wherein the functional device is mylar or a graphite sheet.
